# EUROPEAN PATENT SPECIFICATION

(11) **EP 2 829 354 B1**
(45) Date of publication and mention of the grant of the patent: **27.09.2017**
(21) Application number: 12871855.8
(22) Date of filing: 22.03.2012
(51) Int. Cl.: H05K 13/04, B23P 19/00, B23P 19/02

(54) **CHUCK DEVICE**
SPANNVORRICHTUNG
DISPOSITIF DE MANDRIN

(43) Date of publication of application: 28.01.2015
(73) Proprietor: Fuji Machine Mfg. Co., Ltd., Chiryu-shi, Aichi 472-8686 (JP)
(72) Inventor: IWAKI, Noriaki, Chiryu-shi Aichi 472-8686 (JP); OHTSUBO, Satoru, Chiryu-shi Aichi 472-8686 (JP); IMAMICHI, Takenobu, Chiryu-shi Aichi 472-8686 (JP); MATSUDA, Futoshi, Chiryu-shi Aichi 472-8686 (JP)
(74) Representative: Grünecker Patent- und Rechtsanwälte PartG mbB
(86) International application number: PCT/JP2012/057327
(87) International publication number: WO 2013/140571

(56) References cited:
- JP-A- H02 139 999
- JP-A- H06 252 594
- JP-A- 2007 311 692
- JP-U- H0 617 300
- JP-U- H0 634 300
- US-A- 4 611 846
- US-A- 4 653 794
- US-A- 4 736 517
- US-A- 4 944 086

## Description

### Technical Field

The invention relates to a mounting head comprising a chuck device which is configured to grip (clamp) a component and thrust a downward protrusion of the component into a hole of a workpiece.

### Background Art

A known example of this type chuck device is disclosed in PTL 1 (JP-A-63-236400) and PTL 2 (JP-A-8-8587).

In a chuck device disclosed in PTL 1, a pair of clamp claws using compressed air to perform an opening/closing operation is disposed, and a pusher (rod) disposed to be vertically movable between the pair of clamp claws is biased downward by a spring force. When a component is interposed between and clamped by the pair of clamp claws, a lower end of the pusher is brought into contact with an upper surface of the component and the chuck device is lowered by a predetermined amount. In this manner, after the component is clamped by the pair of clamp claws in a state where the pusher is pushed upward against the spring force, the chuck device
is moved upward from a substrate, a pin of the component is aligned with a hole of the substrate, and the clamp claws are released (clamp release). In this manner, the pusher biased downward by the spring force thrusts the pin of the component into the hole of the substrate.

In contrast, in a chuck device disclosed in PTL 2, a pair of clamp claws is formed from elastic material. In this manner, the pair of clamp claws themselves are elastically deformed to interpose and clamp a component therebetween. A pusher disposed to be vertically movable between the pair of clamp claws is configured to be driven by an actuator (air cylinder, hydraulic cylinder, or solenoid). Then, a pin of the component clamped by a spring force of the pair of clamp claws themselves is aligned with a hole of a substrate. In this manner, the pusher is pushed downward by the actuator, and the pin of the component is thrust into the hole of the substrate.
Document JP H06 34300 U moreover discloses a mounting head according to the preamble of claim 1.

### Citation List

### Patent Literature

PTL 1: JP-A-63-236400
PTL 2: JP-A-8-8587

### Summary of Invention

### Technical Problem

Since components to be mounted on a substrate have different sizes, it is necessary to change the size of clamp claws depending on the size of the component.

However, the chuck devices disclosed in PTL 1 and PTL 2 described above cannot be freely replaced, and thus cannot correspond to the component having various sizes which is to be mounted on the substrate. Moreover, either the clamp claws or the pusher is configured to be operated by the spring force. Consequently, there is a disadvantage in that when operation characteristics are set for a clamp operation and a thrust operation, the setting for any one operation using the spring force between these operations has a lower degree of freedom.

Therefore, an object of the invention is to provide a mounting head comprising a chuck device which can be replaced and can relatively freely set operation characteristics for both a clamp operation and a thrust operation.

### Solution to Problem

In order to achieve the above-described object, the invention is directed to a mounting head comprising a chuck device which is configured to grip a component and thrust a downward protrusion of the component into a hole of a workpiece. The chuck device includes a clamp portion that is configured to clamp the component, a pusher portion that is configured to thrust the downward protrusion of the component into the hole of the workpiece, and two air cylinders that respectively are configured to drive the clamp portion and the pusher portion. The chuck device is held so as to be attached to and detached from the mounting head which is configured to be disposed in a movement mechanism of a component mounting machine, a component insertion machine, and an assembly machine, and is configured so that an air pressure is supplied to the two air cylinders through an air supply path of the mounting head.

In this configuration, the chuck device is attachable to and detachable from the mounting head disposed in the movement mechanism. Accordingly, it is possible to freely replace the chuck device with a new chuck device having a clamp portion matching a size of a component to be clamped. Moreover, the respectively different air cylinders are configured to drive the clamp portion and the pusher portion. Accordingly, it is possible to relatively freely set operation characteristics for both a clamp operation and a thrust operation. The air pressure is supplied to the two air cylinders through the air supply path of the mounting head.
Accordingly, it is also possible to avoid a complicated configuration of the chuck device.

The invention is applicable to any one of a component mounting machine, a component insertion machine, and an assembly machine. However, in a case of being applied to a component mounting machine, it is preferable to configure the chuck device to be held so as to be replaceable with a suction nozzle with respect to the mounting head of the component mounting machine. According to this configuration, the chuck device is used by being held in the mounting head of the component mounting machine, only when production requires the chuck device. In contrast, when the production does not require the chuck device, it is possible to detach the chuck device from the mounting head of the component mounting machine and to use the replaced suction nozzle. Accordingly, it is possible to efficiently use the mounting head which is common to the chuck device and the suction nozzle. Moreover, a positive pressure/negative pressure switching function of the air pressure which is provided for the component mounting machine is utilized in order to switch between a component suction operation and a release operation of the suction nozzle. In this manner, it is possible to drive both the clamp portion and the pusher portion by switching the air pressures to be supplied to the two air cylinders of the chuck device.
Accordingly, it is not necessary to provide the positive pressure/negative pressure switching function of the air pressure for the chuck device itself. Therefore, there is an advantage in that a configuration of the chuck device can be simplified.

According to the invention, when a negative pressure is supplied to the two air cylinders through the air supply path of the mounting head, the clamp portion is driven in a clamp direction in a state where the pusher portion is on standby at a thrust release position, and that when a positive pressure is supplied thereto, the clamp portion is driven in a clamp release direction, and the pusher portion be driven in a thrust direction. According to this configuration, it is possible to control the clamp operation/release operation of the clamp portion and the thrust operation of the pusher portion by switching the air pressures similar to those in a case where the suction nozzle performs a component suction operation/release operation. Therefore, the control for each operation of the chuck device is also facilitated.

In a state where the clamp portion clamps the component, the pusher portion is separated upward from the component and is in a standby state. Consequently, even when the pusher portion is lowered, the pusher portion cannot thrust the protrusion of the component into the hole of the workpiece until the pusher portion reaches the component. For this reason, delay occurs in the operation in which the pusher portion thrusts the component. In a case of the component immediately after the clamp release, the protrusion of the component is insufficiently fitted to the hole of the workpiece. Therefore, if timing for the thrust operation of the pusher portion with respect to the clamp-released component is delayed, there is a possibility that the component falls down before the pusher portion reaches the component.

As a countermeasure, the air cylinder which drives the clamp portion may be configured so that the clamp portion is driven in the clamp release direction after the movement amount of a piston of the air cylinder exceeds a predetermined amount when the clamp portion is driven in the clamp release direction. According to this configuration, it is possible to delay the timing for starting a clamp release operation of the clamp portion until the movement amount of the piston of the air cylinder exceeds the predetermined amount when the clamp portion is driven in the clamp release direction. Accordingly, by adjusting the predetermined amount, it is possible to substantially match the actual timing for starting the clamp release operation of the clamp portion with the timing for causing the pusher portion to start the thrust of the component. Therefore, it is possible to prevent the component from falling down before the pusher portion thrusts the protrusion of the component into the hole of the workpiece.

Alternatively, an air cushion chamber in which air is extruded by the movement of the piston of the air cylinder in the clamp release direction may be disposed in the air cylinder which drives the clamp portion, and an extruding flow rate of the air inside the air cushion chamber may be configured to increase as the movement amount of the piston in the clamp release direction increases. According to this configuration, it is possible to set speed characteristics of the clamp release operation of the clamp portion to be speed characteristics in which an initial speed is set to be slow and the speed of the clamp release operation becomes faster as the piston moves in the clamp release direction. In this manner, when the clamp release operation and the thrust operation of the component are performed, it is possible to prevent the component from falling down in the clamp portion by delaying the speed of the clamp release operation until the pusher portion reaches the component and starts the thrust of the component. Therefore, it is possible to prevent the component from falling down before the pusher portion thrusts the protrusion of the component into the hole of the workpiece.

### Brief Description of Drawings

[Fig. 1] Fig. 1 is a view illustrating a partially broken state in which a chuck device is held in a mounting head of a component mounting machine according to a first embodiment of the invention.
[Fig. 2] Fig. 2(a) is a longitudinal cross-sectional front view of the chuck device when clamp claws of the first embodiment are opened, and Fig. 2(b) is a longitudinal cross-sectional front view of the chuck device when the clamp claws are closed.
[Fig. 3] Fig. 3(a) is a longitudinal cross-sectional side view of the chuck device when a pusher portion of the first embodiment is on standby, and Fig. 3(b) is a longitudinal cross-sectional side view of the chuck device when the pusher portion performs a thrust operation.
[Fig. 4] Fig. 4(a) is a longitudinal cross-sectional front view of a chuck device when clamp claws of a second embodiment are closed, and Fig. 4(b) is a longitudinal cross-sectional front view of the chuck device when the clamp claws are opened.
[Fig. 5] Fig. 5 is a side view of the chuck device of the second embodiment.
[Fig. 6] Fig. 6(a) is an enlarged longitudinal cross-sectional front view of a main portion when the clamp claws of the second embodiment are closed, and Fig. 6(b) is an enlarged longitudinal cross-sectional front view of the main portion when the clamp claws are opened.

### Description of Embodiments

Hereinafter, first and second embodiments in which an aspect for embodying the invention is applied to and realized in a component mounting machine will be described.

### First Embodiment

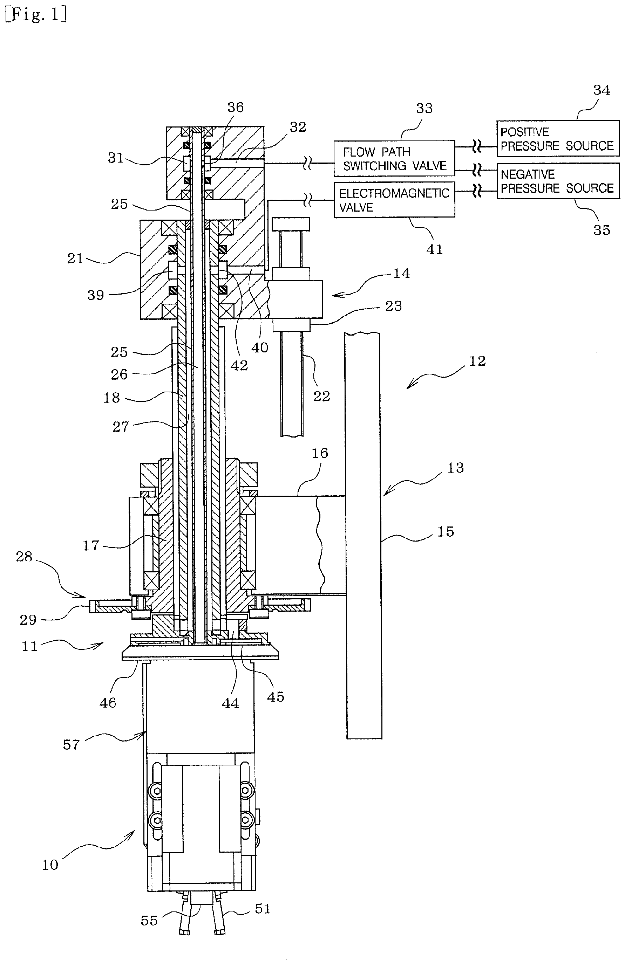

The first embodiment of the invention will be described with reference to Figs. 1 to 3. First, referring to Fig. 1, a configuration of a mounting head 11 side of the component mounting machine which holds a chuck device 10 so as to be attachable thereto and detachable therefrom will be described.

A movement mechanism 12 which holds the mounting head 11 is configured to have an XY direction movement mechanism 13 which moves in an X direction (substrate transport direction) and in a Y direction (direction perpendicular to the substrate transport direction), and a Z direction movement mechanism 14 which moves in a Z direction (vertical direction).

The XY direction movement mechanism 13 is configured so that a Y slider 15 which moves in the Y direction is disposed on an X slider (not illustrated) which moves in the X direction, and a cylindrical rotary member 17 is supported by the Y slider 15 via a support member 16 so that the cylindrical rotary member 17 is rotatable around a Z axis portion 18 (center of an air supply pipe 25 to be described later). The hollow Z axis portion 18 is spline-fitted into the cylindrical rotary member 17 so as to be movable in the Z direction. The mounting head 11 is concentrically disposed in a lower end of the Z axis portion 18.

The Z axis portion 18 protrudes upward from the cylindrical rotary member 17, and an upper end portion of the Z axis portion 18 is rotatably supported by a lift member 21 of the Z direction movement mechanism 14. The Z direction movement mechanism 14 is configured to have a ball screw 22 which is rotatably driven by a Z axis motor (not illustrated) and a nut member 23 which is moved in the Z direction by the rotation of the ball screw 22. The lift member 21 is fixed to the nut member 23.

The air supply pipe 25 is concentrically disposed inside the hollow Z axis portion 18. An internal space of the air supply pipe 25 is used as an air supply path 26 for positive pressure/negative pressure. An annular gap formed between an outer peripheral surface of the air supply pipe 25 and an inner peripheral surface of the Z axis portion 18 is used as an air supply path dedicated to negative pressure 27. An upper end portion of the air supply pipe 25 is rotatably supported by the lift member 21 of the Z direction movement mechanism 14. The movement of the lift member 21 in the Z direction causes the air supply pipe 25 and the Z axis portion 18 to integrally move in the Z direction.

A gear 29 of a head rotating device 28 is disposed in an outer peripheral portion of the cylindrical rotary member 17. The gear 29 is rotated by a motor (not illustrated). In this manner, the cylindrical rotary member 17 is rotated. The Z axis portion 18, the air supply pipe 25, and the mounting head 11 are rotated integrally therewith.

An annular air introduction groove 31 is formed in the lift member 21 along the outer peripheral surface of the air supply pipe 25. An air introduction port 32 extending from an outer peripheral surface of the lift member 21 to the air introduction groove 31 is formed in the lift member 21. A positive pressure source 34 and a negative pressure source 35 are configured to be selectively connected to the air introduction port 32 via a flow path switching valve 33. A communication hole 36 penetrating in a radial direction is formed in a portion opposing the annular air introduction groove 31 within the air supply pipe 25. Positive pressure or negative pressure air introduced to the air introduction port 32 from the positive pressure source 34 or the negative pressure source 35 via the flow path switching valve 33 is supplied to the air supply path for positive pressure/negative pressure 26 inside the air supply pipe 25 from the air introduction groove 31 through the communication hole 36. The positive pressure source 34 is configured to have a blower or a compressor, and the negative pressure source 35 is configured to have a negative pressure pump.

In addition, an annular air introduction groove 39 is formed in the lift member 21 along an outer peripheral surface of the Z axis portion 18. An air introduction port 40 which extends from the outer peripheral surface of the lift member 21 to the air introduction groove 39 is formed in the lift member 21. The air introduction port 40 is connected to the negative pressure source 35 via an electromagnetic valve 41. A communication hole penetrating in the radial direction 42 is formed in a portion exposed to the annular air introduction groove 39 within the Z axis portion 18. The negative pressure introduced from the negative pressure source 35 to the air introduction port 40 via the electromagnetic valve 41 is supplied to the air supply path dedicated to negative pressure 27 inside the Z axis portion 18 from the air introduction groove 39 through the communication hole 42.

A negative pressure chamber for suction 45 which communicates with the air supply path dedicated to negative pressure 27 via a communication path 44 is formed in the mounting head 11 supported in the lower end of the Z axis portion 18 so as to open to a lower surface side. The negative pressure supplied to the negative pressure chamber for suction 45 suctions and holds an upper end surface of the chuck device 10 (or an upper end surface of a suction nozzle).

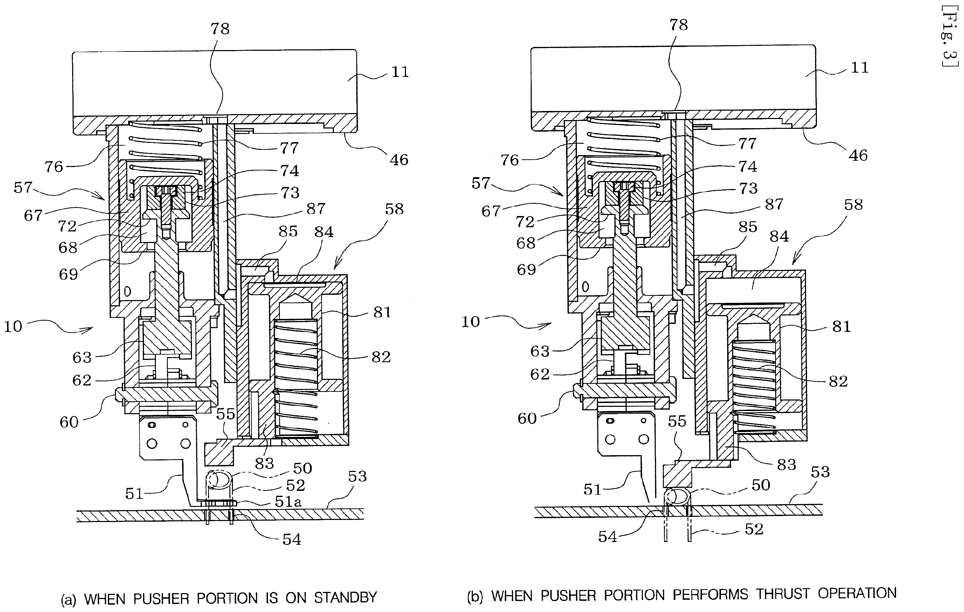

In contrast, a lower end of the air supply path for positive pressure/negative pressure 26 inside the air supply pipe 25 opens to a lower surface of the mounting head 11. The positive pressure/negative pressure air is supplied from the lower end of the air supply path 26 to an air supply port 78 (refer to Fig. 3) on an upper surface wall of the chuck device 10 (or the suction nozzle).

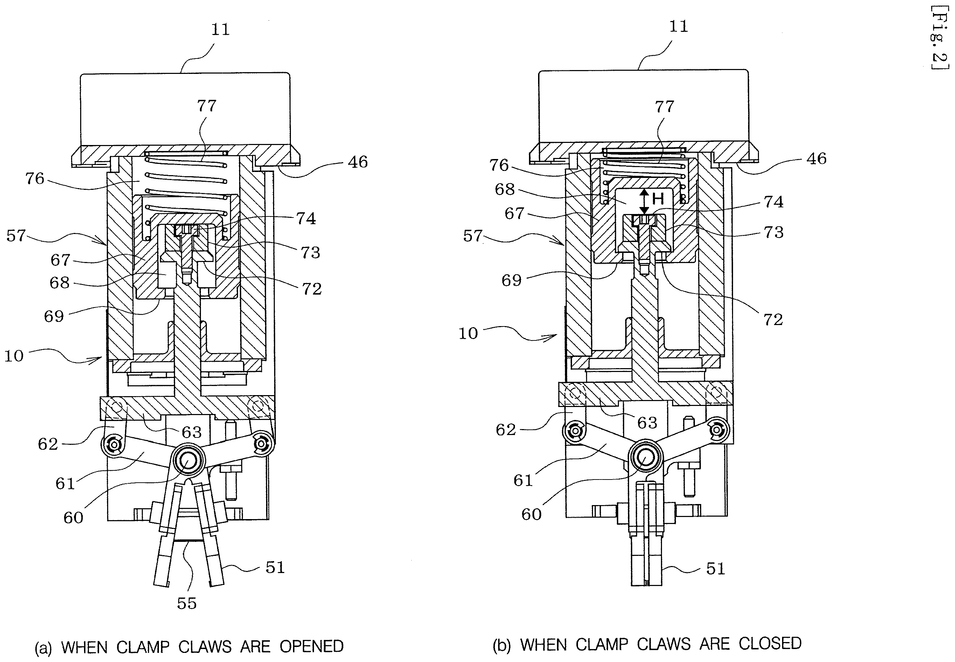

Next, a configuration of the chuck device 10 will be described with reference to Figs. 2 and 3. The chuck device 10 is configured to include a pair of clamp claws 51 (clamp portions) which clamp a component 50, a pusher portion 55 which thrusts a pin 52 (protrusion) of the component 50 into a hole 54 of a substrate 53 (workpiece), an air cylinder for clamp 57 which drives the clamp claws 51, and an air cylinder for pusher 58 which drives the pusher portion 55.

The pair of clamp claws 51 are supported in a downward facing state by a shaft 60 serving as a fulcrum so as to be pivotally movable for opening and closing operations. Arm portions 61 each protruding to the other side are integrally formed in an upper portion of the respective clamp claws 51. If this causes the arm portions 61 to pivotally move downward, the clamp claws 51 are pivotally moved in an opening direction (clamp release direction).

A distal end portion of the arm portions 61 of the respective clamp claws 51 is configured such that a lift member 63 is vertically movable via respective link members 62. A piston 67 of the air cylinder for clamp 57 is connected in a manner that only the piston 67 is vertically movable by a predetermined amount H with respect to an upper end portion of a rod portion of the lift member 63. As will be described later, adjusting the predetermined amount H allows the actual timing for starting the clamp release operation of the clamp claws 51 to substantially match the timing for causing the pusher portion 55 to start the thrust of the component 50.

Specifically, a rod-movable connection chamber 68 is formed in the piston 67 so that the upper end portion of the rod portion of the lift member 63 is vertically movable by the predetermined amount H. The upper end portion of the rod portion is accommodated inside the rod-movable connection chamber 68. A spacer member 73 is fixed to an upper end surface of the rod portion by a screw 74. The spacer member 73 is replaced with a new spacer member having a different thickness. In this manner, it is possible to adjust the actual timing for starting the clamp release operation of the clamp claws 51 by adjusting the predetermined amount H of the piston 67 with respect to the rod portion.

A pressure chamber 76 is formed above the piston 67 of the air cylinder for clamp 57. A spring 77 which biases the piston 67 downward (in the clamp release direction) is accommodated in the pressure chamber 76. The air supply port 78 (refer to Fig. 3) which communicates with the air supply path for positive pressure/negative pressure 26 of the mounting head 11 side is formed on a top wall of the pressure chamber 76 of the air cylinder for clamp 57. The positive pressure/negative pressure air is supplied from the air supply path for positive pressure/negative pressure 26 of the mounting head 11 side to the pressure chamber 76 through the air supply port 78.

As illustrated in Fig. 3, claw tip portions 51a of the pair of clamp claws 51 are formed to be respectively bent in an L-shape, and are arranged so that the pusher portion 55 is located above the component 50 clamped by the two claw tip portions 51a.

Next, referring to Fig. 3, a configuration of the air cylinder for pusher 58 which drives the pusher portion 55 will be described.

A piston 81 of the air cylinder for pusher 58 is biased upward (in the thrust release direction) by a spring force of a spring 82 arranged on a lower side thereof. A rod 83 is integrally formed in a lower portion of the piston 81 so as to protrude downward, and the pusher portion 55 is fixed to the rod 83.

A pressure chamber 84 is formed above the piston 81 of the air cylinder for pusher 58. A communication path 87 which communicates between the air supply port 78 on the upper end surface of the chuck device 10 and an air introduction port 85 on the top wall of the pressure chamber 84 is disposed. The positive pressure/negative pressure air supplied through the air supply path for positive pressure/negative pressure 26 of the mounting head 11 side is supplied to the pressure chamber 84 from the air supply port 78 though the communication path 87. The air supply port 78 on the upper end surface of the chuck device 10 serves as a common air supply port which supplies the air to both of the pressure chambers 76 and 84 of the air cylinder for clamp 57 and the air cylinder for pusher 58.

When the chuck device 10 configured as described above is held by the mounting head 11, the movement mechanism 12 of the component mounting machine causes the mounting head 11 to move upward of the chuck device 10, and the electromagnetic valve 41 of the negative pressure source 35 is opened. Then, while the negative pressure is supplied from the negative pressure source 35 to the negative pressure chamber for suction 45 of the mounting head 11 through the air supply path dedicated to negative pressure 27, the lower surface of the mounting head 11 abuts against the upper surface of the chuck device 10. Then, the chuck device 10 is in a state of being suctioned and held to the lower surface of the mounting head 11 by negative pressure.

Thereafter, when a clamp operation interposing the component 50 between the pair of clamp claws 51 is performed, the flow path switching valve 33 is switched over to the negative pressure source 35 side, and the negative pressure is supplied from the air supply port 78 to the pressure chamber 76 of the air cylinder for clamp 57 through the air supply path for positive pressure/negative pressure 26 of the mounting head 11 side. As illustrated in Fig. 2(b), this causes the piston 67 to be suctioned upward against the spring force of the spring 77. Then, a flange portion 72 of the upper end portion of the rod portion of the lift member 63 is hooked by a retaining plate 69 on the lower surface of the piston 67, and the rod portion is lifted up. The lift member 63 is lifted up integrally with the rod portion. The lifting operation of the lift member 63 causes the arm portions 61 of the pair of clamp claws 51 to be lifted about the shaft 60 serving as a fulcrum via the link members 62. In this manner, the pair of clamp claws 51 are pivotally moved in a closing direction (clamp direction) about the shaft 60 serving as the fulcrum.

During the clamp operation, the negative pressure supplied through the air supply path for positive pressure/negative pressure 26 of the mounting head 11 side is also supplied from the air supply port 78 to the pressure chamber 84 of the air cylinder for pusher 58 through the communication path 87. As illustrated in Fig. 3(a), this causes the piston 81 of the air cylinder for pusher 58 to be suctioned upward. Then, the pusher portion 55 is caused to ascend to an ascending position (thrust release position). This state is maintained by the negative pressure supplied to the pressure chamber 84 and the spring force of the spring 82.

In a state where the clamp claws 51 of the chuck device 10 clamp the component 50 as described above and the pusher portion 55 is caused to be on standby at the thrust release position, the movement mechanism 12 of the component mounting machine causes the chuck device 10 to move upward of the substrate 53 together with the mounting head 11. Then, the pin 52 of the component 50 clamped by the clamp claws 51 of the chuck device 10 is aligned with the hole 54 of the substrate 53. As illustrated in Fig. 3(a), the pin 52 of the component 50 is inserted into the hole 54 of the substrate 53.

Thereafter, the clamp release operation and the thrust operation of the pusher portion 55 are performed as follows. The flow path switching valve 33 is switched over to the positive pressure source 34 side, and the air pressure supplied to the air supply path for positive pressure/negative pressure 26 of the mounting head 11 side is switched over to the positive pressure from the negative pressure. In this manner, the positive pressure air is supplied from the air supply port 78 to both of the pressure chambers 76 and 84 of the air cylinder for clamp 57 and the air cylinder for pusher 58.

If the positive pressure air is supplied to the pressure chamber 76 of the air cylinder for clamp 57, as illustrated in Fig. 2(a), the piston 67 is pushed down by the positive pressure supplied to the pressure chamber 76 and the spring force of the spring 77. In this case, as illustrated in Fig. 2(b), a gap having the predetermined amount H is initially open between the spacer member 73 of the upper end of the rod portion of the lift member 63 and the top wall of the rod-movable connection chamber 68 of the piston 67. Therefore, the rod portion of the lift member 63 is not moved and only the piston 67 is pushed down until an amount in which the spring 77 pushes down the piston 67 exceeds the predetermined amount H. Thereafter, when the pushing-down amount of the piston 67 reaches the predetermined amount H, the top wall of the rod-movable connection chamber 68 is in a state of abutting onto the spacer member 73 of the upper end of the rod portion of the lift member 63. Thereafter, the piston 67 and the rod portion are integrally pushed down, and the lift member 63 is pushed down. This pushing-down operation of the lift member 63 causes the arm portions 61 of the pair of clamp claws 51 to be pushed down about the shaft 60 serving as the fulcrum via the link members 62. Integrally with the arm portions 61, the pair of clamp claws 51 are pivotally moved in an opening direction (clamp release direction) about the shaft 60 serving as the fulcrum.

In this manner, the timing for starting the clamp release operation is delayed from when the positive pressure air starts to be supplied to the pressure chamber 76 of the air cylinder for clamp 57 (the piston 67 starts the pushing-down operation) until the pushing-down amount of the piston 67 exceeds the predetermined amount H.

The positive pressure air supplied from the air supply path for positive pressure/negative pressure 26 of the mounting head 11 side is simultaneously supplied from the air supply port 78 to both of the pressure chambers 76 and 84 of the air cylinder for clamp 57 and the air cylinder for pusher 58. If the positive pressure air is supplied to the pressure chamber 84 of the air cylinder for pusher 58, as illustrated in Fig. 3(b), the piston 81 of the air cylinder for pusher 58 is pushed down against the spring force of the spring 82. This causes the pusher portion 55 to descend, and thus the pusher portion 55 thrusts the pin 52 of the component 50 into the hole 54 of the substrate 53.

The above-described first embodiment has the configuration in which the chuck device 10 is held so as to be attachable to and detachable from the mounting head 11 disposed in the movement mechanism 12 of the component mounting machine. Therefore, it is possible to freely replace the chuck device 10 with a new chuck device 10 having the clamp claws 51 matching a size of the component 50 to be clamped. Moreover, the clamp claws 51 and the pusher portion 55 are configured to be driven by the respectively different air cylinders 57 and 58. Accordingly, it is possible to relatively freely set operation characteristics for both the clamp operation and the thrust operation. The air pressure is configured to be supplied to the two air cylinders 57 and 58 through the air supply path 26 of the mounting head 11. Therefore, it is possible to avoid a complicated configuration of the chuck device 10.

Moreover, the first embodiment has the configuration in which the chuck device 10 is held so as to be replaceable with the suction nozzle with respect to the mounting head 11 of the component mounting machine. Accordingly, the chuck device 10 is used by being held in the mounting head 11 of the component mounting machine, only when production requires the chuck device 10. On the other hand, when the production does not require the chuck device 10, it is possible to detach the chuck device 10 from the mounting head 11 of the component mounting machine and to use the replaced suction nozzle. Accordingly, it is possible to efficiently use the mounting head 11 which is common to the chuck device 10 and the suction nozzle. Moreover, a positive pressure/negative pressure switching function (flow path switching valve 33 and electromagnetic valve 41) of the air pressure which is provided for the mounting head 11 side of the component mounting machine is utilized in order to switch between a component suction operation and a release operation of the suction nozzle. In this manner, it is possible to drive both the clamp claws 51 and the pusher portion 55 by switching the air pressures to be supplied to the two air cylinders 57 and 58 of the chuck device 10. Accordingly, it is not necessary to provide the positive pressure/negative pressure switching function of the air pressure for the chuck device 10 itself. Therefore, there is an advantage in that a configuration of the chuck device 10 can be simplified.

Furthermore, the first embodiment has the configuration in which when the negative pressure is supplied to the two air cylinders 57 and 58 through the air supply path 26 of the mounting head 11, the clamp claws 51 are driven in the clamp direction in a state where the pusher portion 55 is on standby at the thrust release position, and in which when the positive pressure is supplied thereto, the clamp claws 51 are driven in the clamp release direction, and the pusher portion 55 is driven in the thrust direction. According to this configuration, it is possible to perform the clamp operation/release operation of the clamp claws 51 and the thrust operation of the pusher portion 55 by switching the air pressures similar to those in a case where the suction nozzle performs the component suction operation/release operation. Therefore, the control for each operation of the chuck device 10 is also facilitated.

As illustrated in Fig. 3(a), in a state where the component 50 is clamped by the clamp claws 51 of the chuck device 10, the pusher portion 55 is separated upward from the component 50 and is in a standby state. Therefore, even when the pusher portion 55 is caused to descend, the pusher portion 55 cannot thrust the pin 52 of the component 50 into the hole 54 of the substrate 53 until the pusher portion 55 reaches the component 50. For this reason, delay occurs in the operation in which the pusher portion 55 thrusts the component 50. In a case of the component 50 immediately after the clamp release, the pin 52 of the component 50 is insufficiently fitted to the hole 54 of the substrate 53. Therefore, if the timing for the thrust operation of the pusher portion 55 with respect to the clamp-released component 50 is delayed, there is a possibility that the component 50 falls down before the pusher portion 55 reaches the component 50.

As a countermeasure, in the first embodiment, the air cylinder for clamp 57 is configured so that the clamp claws 51 are driven in the clamp release direction after the pushing-down amount of the piston 67 of the air cylinder for clamp 57 exceeds the predetermined amount H when the clamp claws 51 are driven in the clamp release direction. According to this configuration, it is possible to delay the timing for starting the clamp release operation of the clamp claws 51 until the pushing-down amount of the piston 67 of the air cylinder for clamp 57 exceeds the predetermined amount H when the clamp claws 51 are driven in the clamp release direction. Accordingly, by adjusting the predetermined amount H, it is possible to substantially match the actual timing for starting the clamp release operation of the clamp claws 51 with the timing for causing the pusher portion 55 to start the thrust of the component 50. Therefore, it is possible to prevent the component 50 from falling down before the pusher portion 55 thrusts the pin 52 of the component 50 into the hole 54 of the substrate 53.

### Second Embodiment

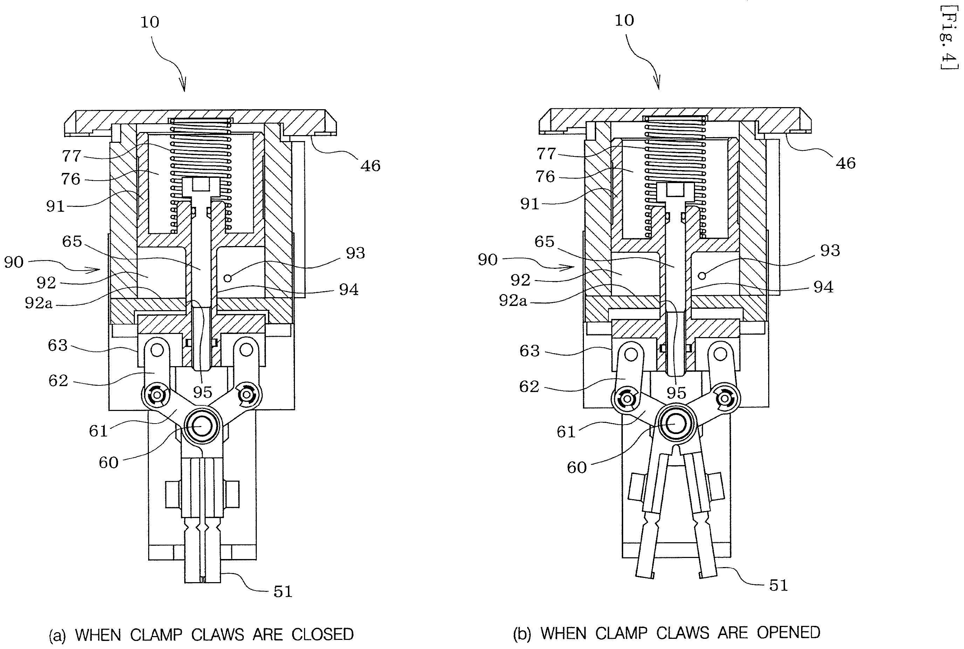

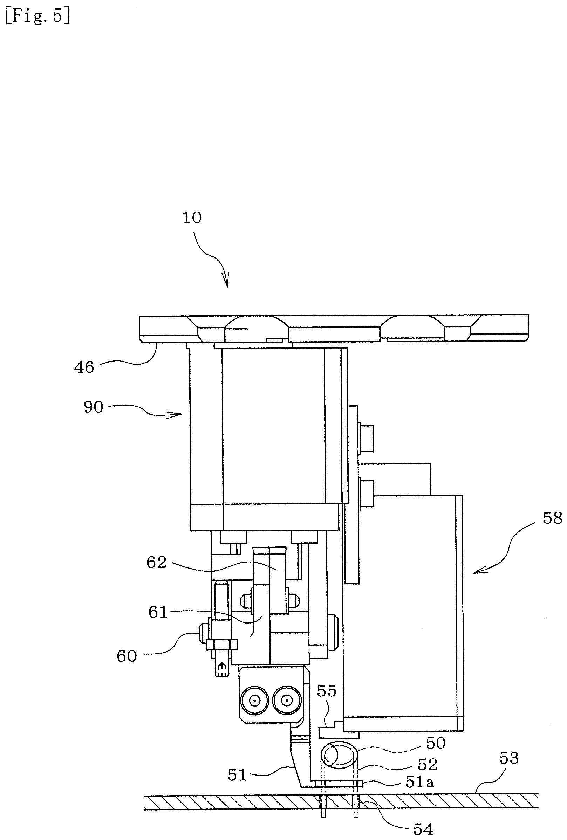

Next, a second embodiment of the invention will be described with reference to Figs. 4 to 6. However, the same reference numerals are given to configuring elements having functions which are substantially the same as those in the above-described first embodiment. Description thereof will be omitted or simplified, and different points will be mainly described.

In the above-described first embodiment, as means for matching the actual timing for starting the clamp release operation of the clamp claws 51 with the timing for causing the pusher portion 55 to start the thrust of the component 50, the clamp claws 51 are configured to be driven in the clamp release direction after the pushing-down amount of the piston 67 of the air cylinder for clamp 57 exceeds the predetermined amount H. However, in the second embodiment, an air cushion chamber 92 in which the air is extruded by descending (movement in the clamp release direction) of a piston 91 is disposed on a lower side of the piston 91 of an air cylinder for clamp 90, which drives the clamp claws 51. An extruding flow rate of the air inside the air cushion chamber 92 increases as a descending amount of the piston 91 increases. In this manner, a descending speed of the piston 91 is configured to increase.

Hereinafter, this configuration will be described in detail. An orifice 93 is formed on a side wall portion of the air cushion chamber 92 of the air cylinder for clamp 90. When the piston 91 descends, the air inside the air cushion chamber 92 is caused to flow out by throttling a flow rate from the orifice 93.

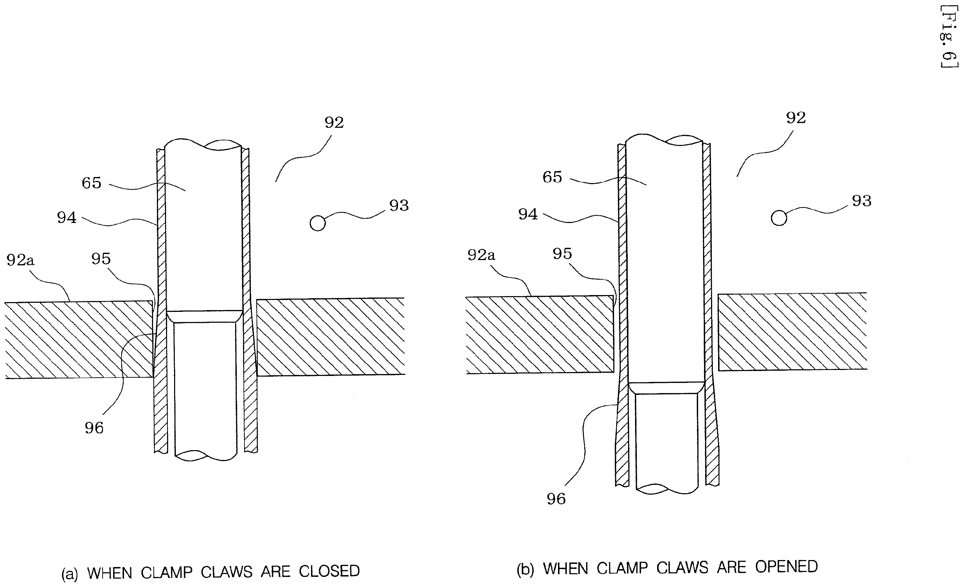

A cylindrical sleeve 94 fixing a rod 65 is formed in the piston 91 so as to protrude downward. The rod 65 is fixedly inserted into the cylindrical sleeve 94. The cylindrical sleeve 94 is vertically movably inserted into a through-hole 95 formed on a bottom wall portion 92a of the air cushion chamber 92. As illustrated in Fig. 6, a tapered surface 96 whose diameter increases downward is formed in a portion opposing an inner peripheral surface of the through-hole 95 within an outer peripheral surface of the cylindrical sleeve 94 so that a gap (cross-sectional area of the flow path) between the outer peripheral surface of the cylindrical sleeve 94 and the inner peripheral surface of the through-hole 95 of the air cushion chamber 92 increases as the descending amount of the piston 91 increases.

In this configuration, when the clamp claws 51 are driven in the clamp release direction, the gap (cross-sectional area of the flow path) between the outer peripheral surface of the cylindrical sleeve 94 and the inner peripheral surface of the through-hole 95 of the air cushion chamber 92 increases as the descending amount of the piston 91 increases. Accordingly, the air inside the air cushion chamber 92 is likely to be extruded, and the pressure applied to the lower surface of the piston 91 by the air inside the air cushion chamber 92 decreases. In this manner, as the descending amount of the piston 91 increases, the descending speed of the piston 91 becomes faster.

According to this configuration, it is possible to set speed characteristics of the clamp release operation of the clamp claws 51 to be speed characteristics in which the initial speed is set to be slow and the speed of the clamp release operation becomes faster as the piston 91 descends. In this manner, when the clamp release operation and the thrust operation of the component 50 are performed, it is possible to prevent the component 50 from falling down by the clamp claws 51 by delaying the speed of the clamp release operation until the pusher portion 55 reaches the component 50 and starts the thrust of the component 50. Therefore, it is possible to prevent the component 50 from falling down before the pusher portion 55 thrusts the pin 52 of the component 50 into the hole 54 of the substrate 53.

In addition, the second embodiment can also obtain the same effect as that of the first embodiment. The second embodiment adopts the configuration in which the cross-sectional area of the flow path of the air extruded from the air cushion chamber 92 continuously increases as the descending amount of the piston 91 increases. However, a configuration may be adopted in which the cross-sectional area of the flow path of the air extruded from the air cushion chamber 92 increases in a stepwise manner (in two or more stages) as the descending amount of the piston 91 increases.

The applicable scope of the invention is not limited to the component mounting machine, and the invention can also be applied to a component insertion machine, an assembly machine, and the like.

In addition, the invention is not limited to the above-described first and second embodiments. For example, the shape of the clamp claws 51 or the shape of the pusher portion 55 may be appropriately changed. Various modifications of the invention can be implemented within a scope without departing from the scope of the appended claims.

### Reference Signs List

10 chuck device, 11 mounting head, 12 movement mechanism, 13 XY direction movement mechanism, 14 Z direction movement
mechanism, 18 Z axis portion, 26 air supply path for positive pressure/negative pressure, 27 air supply path dedicated to negative pressure, 28 head rotating device, 33 flow path switching valve, 34 positive pressure source, 35 negative pressure source, 41 electromagnetic valve, 45 negative pressure chamber for suction, 50 component, 51 clamp claw (clamp portion), 52 pin (protrusion), 53 substrate (workpiece), 54 hole, 55 pusher portion, 57 air cylinder for clamp, 58 air cylinder for pusher, 61 arm portion, 62 link member, 63 lift member, 67 piston, 68 rod-movable connection chamber, 73 spacer member, 76 pressure chamber, 77 spring, 78 air supply port, 81 piston, 82 spring, 83 rod, 84 pressure chamber, 90 air cylinder for clamp, 91 piston, 92 air cushion chamber, 93 orifice, 94 cylindrical sleeve, 96 tapered surface

## Claims

1. A mounting head (11) comprising a chuck device (10) which is configured to grip a component (50) and thrust a downward protrusion (52) of the component (50) into a hole (54) of a workpiece (53), the chuck device (10) comprising:
a clamp portion (51) that is configured to clamp the component (50);
a pusher portion (55) that is configured to thrust the downward protrusion (52) of the component (50) into the hole (54) of the workpiece (53); and
two air cylinders (57, 58) that respectively are configured to drive the clamp portion (51) and the pusher portion (55),
wherein the chuck device (10) is held so as to be attached to and detachable from the mounting head (11) which is configured to be disposed in a movement mechanism (12), and is configured so that air pressure is supplied to the two air cylinders (57, 58) through an air supply path (26) of the mounting head (11),
**characterized in that**
when a negative pressure is supplied to the two air cylinders (57, 58) through the air supply path (26) of the mounting head (11), the clamp portion (51) is driven in a clamp direction in a state where the pusher portion (55) is on standby at a thrust release position, and
when a positive pressure is supplied thereto, the clamp portion (51) is driven in a clamp release direction, and the pusher portion (55) is driven in a thrust direction.

2. The mounting head (11) according to claim 1,
wherein the mounting head (11) is a mounting head of a component mounting machine, and
wherein the chuck device (10) is configured to be held so as to be replaceable with a suction nozzle for suctioning the component (50) with respect to the mounting head (11) of the component mounting machine.

3. The mounting head (11) according to claim 1,
wherein the air cylinder (57) which is configured to drive the clamp portion (51) is configured so that the clamp portion (51) is driven in the clamp release direction after a movement amount of a piston (67) of the air cylinder (57) exceeds a predetermined amount (H) when the clamp portion (51) is driven in the clamp release direction.

4. The mounting head (11) according to claim 1,
wherein an air cushion chamber (92) in which air is extruded by a movement of the piston (91) of the air cylinder (90) in the clamp release direction is disposed in the air cylinder (90) which is configured to drive the clamp portion (51), and
wherein an extruding flow rate of the air inside the air cushion chamber (92) increases as the movement amount of the piston (91) in the clamp release direction increases.

## Patentansprüche

1. Montagekopf (11) mit einer Spannvorrichtung (10), die ausgebildet ist eine Komponente (50) zu greifen und einen abwärtsgerichteten Vorsprung (52) der Komponente (50) in eine Bohrung (54) eines Werkstücks (53) zu drücken, wobei die Spannvorrichtung (10) aufweist:
einen Klemmbereich (51), der ausgebildet ist, die Komponente (50) durch Klemmung zu halten;
einen Schiebebereich (55), der ausgebildet ist, den abwärtsgerichteten Vorsprung (52) der Komponente (50) in die Bohrung (54) des Werkstücks (53) zu drücken; und
zwei Luftzylinder (57, 58), die jeweils ausgebildet sind, den Klemmbereich (51) und den Schiebebereich (55) anzutreiben,
wobei die Spannvorrichtung (10) so gehalten ist, dass sie an dem Montagekopf (11) anbringbar und davon abnehmbar ist, der ausgebildet ist, in einem Bewegungsmechanismus (12) angeordnet zu sein, und einen Aufbau hat, wonach den zwei Luftzylindern (57, 58) über einen Luftversorgungskanal (26) des Montagekopfs (11) Luftdruck zugeführt wird,
**dadurch gekennzeichnet, dass**
wenn den zwei Luftzylindern (57, 58) über den Druckluftversorgungskanal (26) des Montagekopfs (11) Unterdruck zugeleitet ist, der Klemmbereich (51) in einer Klemmrichtung in einem Zustand angetrieben wird, in welchem der Schiebebereich (55) an einer Schubentlastungsposition in Bereitschaft ist, und
wenn ein Überdruck zugeführt wird, der Klemmbereich (51) in einer Klemmlöserichtung angetrieben wird und der Schiebebereich (55) in einer Schubrichtung angetrieben wird.

2. Montagekopf (11) nach Anspruch 1,
wobei der Montagekopf (11) ein Montagekopf einer Kompontenmontageanlage ist, und
wobei die Spannvorrichtung (10) ausgebildet ist, so gehalten in Bezug auf den Montagekopf (11) der Komponentenmontageanlage zu werden, dass sie durch eine Saugdüse zum Ansaugen der Komponente (50) ersetzbar ist.

3. Montagekopf (11) nach Anspruch 1,
wobei der Luftzylinder (57), der zum Antreiben des Klemmbereichs (51) ausgebildet ist, so ausgebildet ist, dass der Klemmbereich (51) in der Klemmlöserichtung angetrieben wird, nachdem der Bewegungsbetrag eines Kolbens (67) des Luftzylinders (57) beim Antreiben des Klemmbereichs (51) in der Klemmlöserichtung einen vorbestimmten Betrag (H) überschritten hat.

4. Montagekopf (11) nach Anspruch 1,
wobei eine Luftdämpfungskammer (92), in der Luft durch eine Bewegung des Kolbens (91) des Luftzylinders (90) in der Klemmlöserichtung ausgestoßen wird, in dem Luftzylinder (90) angeordnet ist, der zum Antreiben des Klemmbereichs (51) ausgebildet ist, und
wobei eine Ausstoßdurchflussrate der Luft im Inneren der Luftdämpfungskammer (92) mit zunehmendem Betrag der Bewegung des Kolbens (91) in der Klemmlöserichtung ansteigt.

## Revendications

1. Tête de montage (11) comprenant un dispositif de mandrin (10) qui est configuré pour saisir un composant (50) et pour pousser une protubérance (52) dirigée vers le bas du composant dans un trou (54) d'une pièce à usiner (53), le dispositif de mandrin (10) comprenant :
une partie de serrage (51) qui est configurée pour bloquer le composant (50),
une partie formant poussoir (55) qui est configurée pour pousser la protubérance (52) dirigée vers le bas du composant (50) dans le trou (54) de la pièce à usiner (53), et
deux vérins pneumatiques (57, 58) qui sont respectivement configurés pour piloter la partie de serrage (51) et la partie formant poussoir (55),
dans laquelle le dispositif de mandrin (10) est maintenu de façon être fixé à la tête de montage (11) et peut être démonté de celle-ci, laquelle est configurée pour être disposée dans un mécanisme de mouvement (12), et il est configuré de sorte à ce que de l'air sous pression soit fourni aux deux vérins pneumatiques (57, 58) par l'intermédiaire d'un passage d'alimentation en air (26) sur la tête de montage (11),
**caractérisée en ce que**
lorsqu'une pression négative est appliquée sur les deux vérins pneumatiques (57, 58) par l'intermédiaire du passage d'alimentation en air (26) de la tête de montage (11), la partie de serrage (51) est pilotée dans une direction de blocage où la partie formant poussoir (55) est en attente au niveau d'une position de libération de poussée, et
lorsqu'une pression positive est appliquée à ceux-ci, la partie de serrage (51) est pilotée dans une direction de libération de blocage et la partie formant poussoir (55) est pilotée dans une direction de poussée.

2. Tête de montage (11) selon la revendication 1,
la tête de montage (11) étant une tête de montage appartenant à une machine de montage de composants, et
dans laquelle le dispositif de mandrin (10) est configuré pour être maintenu de façon à pouvoir être remplacé avec une buse d'aspiration permettant d'aspirer le composant (50) par rapport à la tête de montage (11) de la machine de montage de composants.

3. Tête de montage (11) selon la revendication 1,
dans laquelle le vérin pneumatique (57), qui est configuré pour piloter la partie de serrage (51), est configuré de sorte à ce que la partie de serrage (51) soit pilotée dans la direction de libération de blocage après qu'une certaine quantité de mouvement d'un piston (67) du vérin pneumatique (57) a dépassé une valeur prédéterminée (H) lorsque la partie de serrage (51) est pilotée dans la direction de libération de blocage.

4. Tête de montage (11) selon la revendication 1,
dans laquelle un compartiment formant tampon pneumatique (92), dans lequel est extrudé l'air par un mouvement du piston (91) du vérin pneumatique (90) dans la direction de libération de blocage, est disposé dans le vérin pneumatique (90) qui est configuré pour piloter la partie de serrage (51), et
dans lequel le débit d'écoulement d'extrusion de l'air à l'intérieur du compartiment formant tampon pneumatique (92) augmente à mesure qu'augmente la quantité de mouvement du piston (91) dans la direction de libération de blocage.
